# EUROPEAN PATENT APPLICATION

(11) **EP 4 791 164 A1**
(43) Date of publication of application: **12.08.2026**
(21) Application number: 24875011.9
(22) Date of filing: 07.10.2024
(51) Int. Cl.: H10K 59/80, H10K 59/131, H10K 59/12, H10K 71/00, H10K 71/60

(54) **ORGANIC LIGHT-EMITTING DISPLAY DEVICE**

(30) Priority: 06.10.2023 KR 20230133720; 04.10.2024 KR 20240134922
(71) Applicant: Yas Co., Ltd., Paju-si, Gyeonggi-do 10857 (KR); Ahn, Byungchul, Seoul 06574 (KR)
(72) Inventor: AHN, Byungchul, Seoul 06574 (KR)
(74) Representative: Epping - Hermann - Fischer
(86) International application number: PCT/KR2024/015148
(87) International publication number: WO 2025/075456

(57) **Abstract**

The organic light-emitting display device may include a plurality of anode electrodes on a plurality of subpixels, a plurality of organic light-emitting layers on the plurality of anode electrodes, a plurality of cathode electrodes on the plurality of organic light-emitting layers, a plurality of inorganic insulating layers on the plurality of cathode electrodes, a plurality of first protrusion parts disposed between a plurality of subpixels in a first direction and having a plurality of first undercut structures on the side portions thereof, a plurality of first waterproof structures on the plurality of first protrusion parts, and a plurality of second waterproof structures in the plurality of first undercut structures of the plurality of first protrusion parts. The first waterproof structure may be configured such that at least two or more inorganic insulating layers among the plurality of inorganic insulating layers are overlapped on the first protrusion parts.

## Description

### [Technical Field]

The embodiment relates to an organic light- emitting display device.

### [Background Art]

As the demand for portable information media increases, attempts to apply an organic light-emitting display device to various lightweight and thin information electronic devices are expanding. Recently, the organic light-emitting display device is being applied to product groups such as a mobile PC and an automobile rather than a TV or a mobile phone. Since the organic light-emitting display device applied to the mobile PC or the automobile is driven as still image for a long time, long lifespan is required. In order to achieve long lifespan, the extraction of light from the organic light-emitting element equipped in the organic light-emitting display device should be maximized. In addition, in order to reduce cost, it is necessary to expand the technology to enable the production of organic light-emitting elements on substrates of not only 8.5th generation (2200x2,500mm) but also 10.5th generation (3370x2940mm). In order to produce long-lifespan organic light-emitting elements, each subpixel with a top emission structure and a side-by-side structure must be implemented as a structure of an organic light-emitting element of two or more stacks.

The structure of such an organic light-emitting element may be obtained through a deposition equipment using a fine metal mask (FMM, hereinafter referred to as FMM). However, the deposition method using FMM has the problem of low productivity because the production logistics must be produced only in a cluster method rather than an in-line method. In addition, there is a problem of low PPA (pixel position accuracy) between the FMM and the substrate in a subpixel unit. Accordingly, the emission area ratio (EAR) is small, which limits the product lifespan. Here, EAR is the value obtained by dividing the emission area of a subpixel by the total area of the subpixel.

Therefore, the development of a new deposition method to solve the aforementioned problems and an organic light-emitting display device having a structure of a new organic light-emitting element using the new deposition method is very urgent.

### [Disclosure]

### [Technical Problem]

An object of the embodiment is to solve the foregoing and other problems.

Another object of the embodiment is to provide an organic light-emitting display device having a novel structure.

Another object of the embodiment is to provide an organic light-emitting display device capable of improving lifespan.

Another object of the embodiment is to provide an organic light-emitting display device capable of improving productivity and yield.

Another object of the embodiment is to provide an organic light-emitting display device capable of improving image quality.

The technical problems of the embodiments are not limited to those described in this item and comprise those that may be understood through the description of the invention.

### [Technical Solution]

In order to achieve the above or other objects, according to one aspect of the embodiment, an organic light-emitting display device, comprising: a plurality of subpixels having different colors along a first direction and having a same color along a second direction crossing the first direction; a plurality of anode electrodes on the plurality of subpixels; a plurality of organic light-emitting layers on the plurality of anode electrodes; a plurality of cathode electrodes on the plurality of organic light-emitting layers; a plurality of inorganic insulating layers on the plurality of cathode electrodes; a plurality of first protrusion parts disposed between the plurality of subpixels along the first direction and having a plurality of first undercut structures on side portions thereof; a plurality of first waterproof structures on the plurality of first protrusion parts; and a plurality of second waterproof structures in the plurality of first undercut structures of the plurality of first protrusion parts, wherein the first waterproof structure is configured such that at least two or more inorganic insulating layers among the plurality of inorganic insulating layers are overlapped on the first protrusion parts.

The first protrusion part may comprise a column layer and a roof layer on the column layer, the first undercut structure may be formed by a width of the column layer being smaller than a width of the roof layer, and the organic light-emitting layer may be disposed on side portions of the column layer.

A width between emission regions of the plurality of subpixels in the first direction may be the width of the column layer.

The second waterproof structure may be configured such that one of the plurality of inorganic insulating layers is formed as a joint structure of an inorganic film/an inorganic film by the first undercut structure.

The organic light-emitting display device may further comprise a plurality of second protrusion parts between the plurality of subpixels in the second direction.

The organic light-emitting display device may further comprise a plurality of third waterproof structures on side portions of the plurality of second protrusion parts, the second protrusion parts may comprise a column layer and a roof layer on the column layer, and a width of the column layer may be smaller than a width of the roof layer, so that second undercut structures are formed on the side portions of the second protrusion part.

The organic light-emitting display device may further comprise a plurality of connection structures on the second undercut structures of the second protrusion parts.

The organic light-emitting display device may further comprise an open structure on an edge region of at least one or more of the first protrusion part and the second protrusion par.

The organic light-emitting display device may further comprise a display regions comprising the plurality of sub-pixels; a non-display regions comprising a plurality of dummy sub-pixels; a plurality of third protrusions extending from the plurality of first protrusions to the non-display regions along the second direction; and a plurality of third waterproof structures on the plurality of third protrusions.

The organic light-emitting display device may further comprise a plurality of first banks below the plurality of first protrusion parts, and the organic light-emitting layer may be disposed on an upper side of the first bank.

The organic light-emitting display device may further comprise a plurality of second banks between the plurality of subpixels in the second direction, and the cathode electrode may be disposed continuously on the subpixels adjacent to the second bank on the second bank.

### [Advantageous Effects]

The effects of the organic light-emitting display device according to the embodiment are described as follows.

According to at least one of the embodiments, since there is no need to use an FMM, the process can be simplified and the process cost can be reduced.

According to at least one of the embodiments, since there is no need to use an FMM, the EAR in the subpixel can be increased, and the lifespan can be improved.

According to at least one of the embodiments, an organic light-emitting element is deposited on a large-area substrate in an in-line deposition system, so that productivity, yield, and material utilization efficiency can be improved.

According to at least one of the embodiments, a width between the emission region of each of a plurality of subpixels in a first direction may be reduced to a width of a column layer of a first protrusion part, so that the corresponding emission region may be increased, which can increase lifespan and brightness, and improve image quality.

According to at least one of the embodiments, a plurality of connection structures may be disposed in the first grooves of a plurality of first banks between a plurality of subpixels in a second direction. Accordingly, as a cathode electrode of each subpixel is be electrically connected to a first power wiring through the plurality of connection structures, electrical connection between the cathode electrode and the first power wiring can be facilitated and disconnection defect can be prevented, so that operation defects or light-emitting defects of the subpixel can be prevented, and reliability can be improved.

According to at least one of the embodiments, a plurality of waterproof structures may be disposed in the protrusion part, so that penetration of moisture, oxygen, etc. can be completely blocked.

According to at least one of the embodiments, a plurality of open structures may be disposed at an edge of the column layer of the bank and/or the protrusion part. Accordingly, a transverse leakage current or a longitudinal leakage current can be prevented, so that poor image quality such as color spot can be prevented, and luminescence efficiency and luminance can be significantly improved. In addition, as electrical shorts between the anode electrode and the cathode electrode within the corresponding subpixel are prevented, operation defects or light-emitting defects can be prevented, so that product reliability can be improved.

Additional scope of applicability of the embodiments will become apparent from the detailed description that follows. However, since various changes and modifications within the idea and scope of the embodiments may be clearly understood by those skilled in the art, the detailed description and specific embodiments, such as preferred embodiments, should be understood as being given by way of example only.

### [Description of Drawings]

FIG. 1 is a plan view schematically illustrating an organic light-emitting display device according to a first embodiment.
FIG. 2 is a cross-sectional view illustrating an organic light-emitting display device according to a first embodiment.
FIG. 3 is a cross-sectional view illustrating an organic light-emitting display device according to a second embodiment.
FIG. 4 is a cross-sectional view illustrating an organic light-emitting display device according to a third embodiment.
FIG. 5 is a plan view schematically illustrating an organic light-emitting display device according to a second embodiment.
FIG. 6 is a cross-sectional view illustrating an organic light-emitting display device according to a fourth embodiment.
FIG. 7 is a cross-sectional view illustrating an organic light-emitting display device according to a fifth embodiment.

The sizes, shapes, dimensions, etc. of elements illustrated in the drawings may differ from actual ones. In addition, even if the same elements are illustrated in different sizes, shapes, dimensions, etc. between the drawings, this is only an example on the drawing, and the same elements have the same sizes, shapes, dimensions, etc. between the drawings.

### [Mode for Invention]

Hereinafter, the embodiment disclosed in this specification will be described in detail with reference to the accompanying drawings, but the same or similar elements are given the same reference numerals regardless of reference numerals, and redundant descriptions thereof will be omitted. The suffixes 'module' and 'unit' for the elements used in the following descriptions are given or used interchangeably in consideration of ease of writing the specification, and do not themselves have a meaning or role that is distinct from each other. In addition, the accompanying drawings are for easy understanding of the embodiment disclosed in this specification, and the technical idea disclosed in this specification is not limited by the accompanying drawings. Also, when an element such as a layer, region or substrate is referred to as being 'on' another element, this means that there may be directly on the other element or be other intermediate elements therebetween.

Hereinafter, an organic light-emitting display device having a side-by-side structure manufactured using a photolithography process is disclosed. This structure is called Ph-SbS (side-by-side structure by photolithography). By using a photolithography process, there is no need to use an FMM, so that the process can be simplified and the process cost can be reduced. In addition, the EAR within the subpixel may be increased, so that the lifespan can be improved. In addition, since the organic light-emitting element is deposited on a large-area substrate in an in-line deposition system, productivity, yield, and material utilization efficiency can be improved.

Hereinafter, a red subpixel may be named a first subpixel, a green subpixel may be named a second subpixel, and a blue subpixel may be named a third subpixel. In addition, the red organic light-emitting element may be named as a first organic light-emitting element, the green organic light-emitting element may be named as a second organic light-emitting element, and the blue organic light-emitting element may be named as a third organic light-emitting element.

Hereinafter, the organic light-emitting display device is a top-emission type in which light is emitted in an upper direction of the substrate to display an image, but a bottom-emission type in which light is emitted in a lower direction of the substrate to display an image may also be included in the technical idea of the present invention.

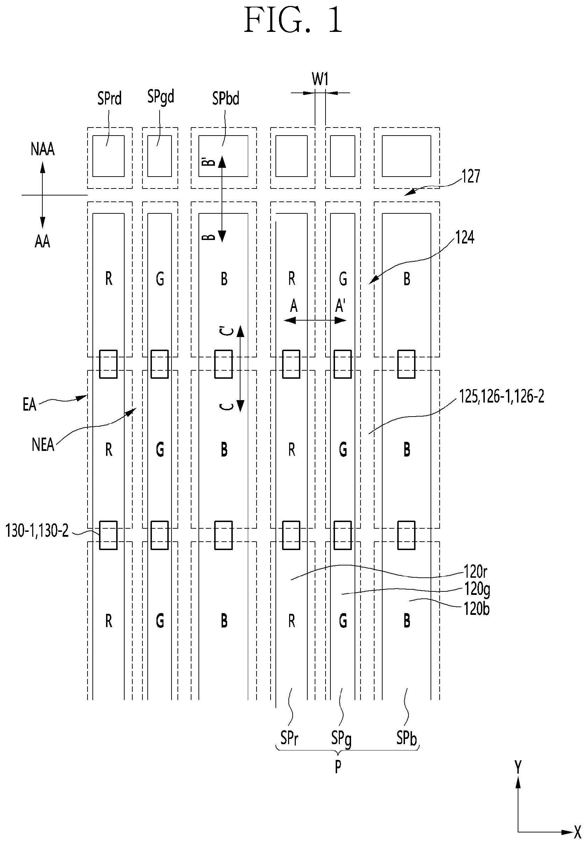

FIG. 1 is a plan view schematically illustrating an organic light-emitting display device according to a first embodiment.

As illustrated in FIG. 1, the organic light-emitting display device according to the first embodiment may comprise a plurality of pixels P arranged in a matrix. The plurality of pixels P may be arranged in a display region AA. The remaining region excluding the display region AA may be defined as a non-display region NAA.

The plurality of pixels P may comprise, for example, a plurality of red subpixels SPr, a plurality of green subpixels SPg, a plurality of blue subpixels SPb, etc. The plurality of subpixels SPr, SPg, and SPb may have different colors along the first direction X and the same color along the second direction Y, but is not limited thereto. That is, the plurality of subpixels SPr, SPg and SPb may have a stripe pattern disposed lengthwise along the second direction Y and have the same color.

The organic light-emitting layer and the cathode electrode of each of the plurality of organic light-emitting elements 120r, 120g, and 120b may have the same color along the second direction Y and may have a stripe pattern disposed in a long manner. For example, the plurality of red subpixels SPr emitting red light may be arranged in a stripe shape along the second direction Y. For example, the plurality of green subpixels SPg emitting green light may be arranged in a stripe shape along the second direction Y. For example, the plurality of green subpixels SPg emitting blue light may be arranged in a stripe shape along the second direction Y.

The red subpixel SPr, the green subpixel SPg, and the blue subpixel SPb may be alternately arranged in a column-line unit along the first direction X, so that an organic light-emitting display device having a side-by-side structure may be implemented. For example, the red subpixel SPr, the green subpixel SPg, and the blue subpixel SPb may be alternately arranged in the order of the first direction X, but is not limited thereto.

For example, the red organic light-emitting element 120r may be disposed in the red subpixel SPr, the green organic light-emitting element 120g may be disposed in the green subpixel SPg, and the blue organic light-emitting element 120b may be disposed in the green subpixel SPg.

The plurality of subpixels SPr, SPg, and SPb may each comprise an emission region EA and a non- emission region NEA. The emission region EA is a region where the organic light-emitting elements 120r, 120g, and 120b are disposed, and the non-emission region NEA may be defined as the remaining region excluding the emission region EA.

The red organic light-emitting element 120r, the green organic light-emitting element 120g, and the blue organic light-emitting element 120b may each comprise an anode electrode, an organic light-emitting layer, a cathode electrode, etc. The organic light-emitting layer may comprise a hole injection layer, a hole transport layer, an organic emission layer, an electron transport layer, an electron injection layer, a charge generation layer, etc. The red organic light-emitting element 120r, the green organic light-emitting element 120g, and the blue organic light-emitting element 120b may each comprise at least two or more stack structures. Each stack structure may comprise an organic emission layer that emits light.

The organic light-emitting layer and the cathode electrode may be disposed only in each of the plurality of subpixels SPr, SPg, and SPb along the first direction X. That is, the organic light-emitting layer and the cathode electrode may not be disposed continuously along the first direction X but may be separated from each other. Alternatively, as described above, the organic light-emitting layer and the cathode electrode of each of the plurality of organic light-emitting elements 120r, 120g, and 120b may have a stripe pattern having the same color and disposed lengthwise along the second direction Y. That is, the organic light-emitting layer and the cathode electrode may be disposed across the plurality of subpixels SPr, SPg, and SPb, respectively, along the second direction Y. That is, the organic light-emitting layer and the cathode electrode may be disposed to connect not only the plurality of subpixels SPr, SPg, and SPb, but also the regions between the plurality of subpixels SPr, SPg, and SPb, respectively, along the second direction Y.

Meanwhile, although not illustrated, a plurality of power wirings may be provided to supply power to the plurality of subpixels SPr, SPg, and SPb in order to supply a first potential voltage.

The plurality of power wirings may comprise a plurality of first power wirings and a plurality of second power wirings disposed in the display region AA and a third power wiring disposed in the non-display region NAA.

The plurality of first power wirings and the plurality of second power wirings may be disposed in a matrix structure with each other in the display region AA. The plurality of first power wirings may be disposed in regions between the plurality of subpixels SPr, SPg, and SPb along the second direction Y, and the plurality of second power wirings may be disposed in regions between the plurality of subpixels SPr, SPg, and SPb along the first direction X. The third power wiring may electrically connect a power terminal and the second power wiring in the non-display region NAA.

The plurality of subpixels SPr, SPg, and SPb may each comprise a driving circuit comprising a driving transistor, etc.

Although not illustrated, another power wiring may be provided to supply a second potential voltage greater than the first potential voltage. Another power wiring may be electrically connected to the driving transistors of each of the subpixels SPr, SPg, and SPb, but is not limited thereto.

When specific subpixels SPr, SPg, and SPb are selected by the scan transistors responding to the scan signal, light having a luminance corresponding to the current flowing in the driving transistor may be emitted from the specific subpixels SPr, SPg, and SPb by using the first potential voltages of the plurality of power wirings and the second potential voltage of another power wirings.

Meanwhile, a plurality of protrusion parts 124 and 127 may be disposed between the plurality of subpixels SPr, SPg, and SPb. As will be described later, the protrusion parts 124 and 127 may be members that protrude upward with respect to the upper surfaces of the organic light-emitting elements 120r, 120g, and 120b of the plurality of subpixels SPr, SPg, and SPb, respectively.

The plurality of protrusion parts may comprise a plurality of first protrusion parts 124 and a plurality of second protrusion parts 127. The plurality of first protrusion parts 124 may be disposed between a plurality of subpixels SPr, SPg, and SPb on the first direction X, and the plurality of second protrusion parts 127 may be disposed between a plurality of subpixels SPr, SPg, and SPb on the second direction Y.

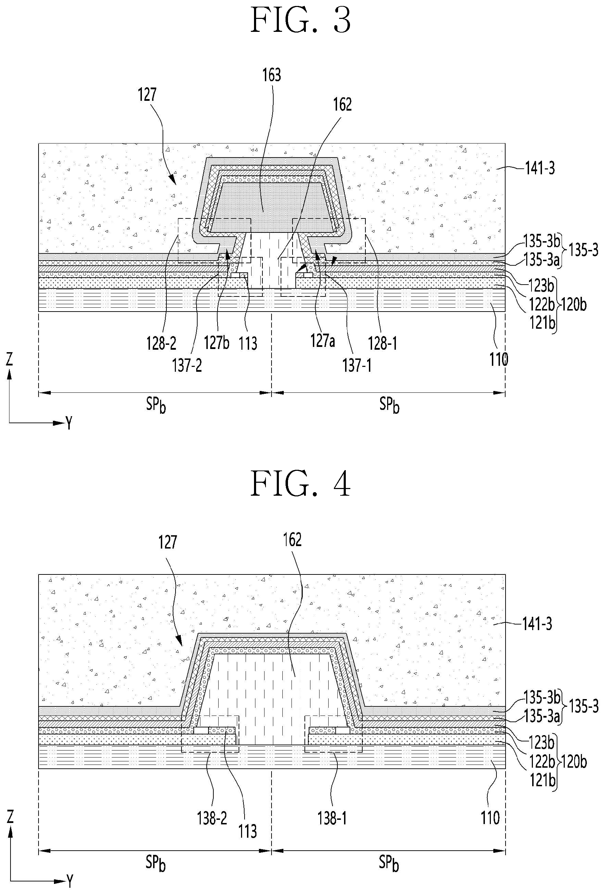

The plurality of first protrusion parts 124 may extend between a plurality of dummy subpixels SPrd, SPgd, and SPbd on the non-display region NAA, and may be formed as third protrusion parts. The non-display region NAA is a region vulnerable to penetration of moisture, oxygen, etc. In an embodiment, by providing a plurality of fourth waterproof structures on the third protrusion part, penetration of moisture, oxygen, etc. can be prevented. A plurality of fourth waterproof structures may be provided between the plurality of dummy subpixels SPrd, SPgd and SPbd on the first direction X or between the plurality of dummy subpixels SPrd, SPgd and SPbd on the first direction X and the plurality of dummy subpixels SPrd, SPgd and SPbd on the second direction Y. The fourth waterproof structures may be the same as the structure of the third waterproof structures 128-1 and 128-2 illustrated in FIG. 3.

A plurality of waterproof structures 125, 126-1 and 26-2, a plurality of open structures, etc. may be disposed on the first protrusion part 124 between the plurality of subpixels SPr, SPg and SPb on the first direction X. A plurality of connecting structures 130-1 and 130-2 may be disposed on the second protrusion part 127 between the plurality of subpixels SPr, SPg and SPb on the second direction Y.

Since the first protrusion part 124 is formed with a structure capable of not only waterproof blocking but also electrical blocking, a plurality of open structures may be omitted. For example, when the influence of image quality due to the leakage current between the plurality of subpixels SPr, SPg and SPb on the first direction X, i.e., the lateral leakage current is minimal, a plurality of open structures may not be disposed between the plurality of subpixels SPr, SPg and SPb on the first direction X. The connection structures 130-1 and 130-2 may electrically connect the second power wiring disposed between the plurality of subpixels SPr, SPg, and SPb on the second direction Y to the plurality of cathode electrodes of the plurality of organic light-emitting elements 120r, 120g, and 120b of the plurality of subpixels SPr, SPg, and SPb.

The open structure may be a structure that separates layers comprising low-resistance organic light-emitting materials of each of the organic light-emitting elements 120r, 120g, and 120b, such as a hole injection layer, a charge generation layer, etc., thereby preventing electrical shorts between the anode electrode and the cathode electrode and reducing leakage current between subpixels.

As will be explained later, the transverse leakage current or the longitudinal leakage current between the plurality of subpixels SPr, SPg, and SPb can be prevented by the open structure. The transverse leakage current is a leakage current flowing between adjacent subpixels SPr, SPg, and SPb along the first direction X, and the longitudinal leakage current may be a leakage current flowing between adjacent subpixels SPr, SPg, and SPb along the second direction Y. In addition, the electrical short between the anode electrode and the cathode electrode in the corresponding subpixels SPr, SPg, and SPb can be prevented by the open structure. Therefore, by using the open structure, color spot due to the leakage current can be improved, and luminescence efficiency and luminance can be significantly improved. In addition, the electrical short between the anode electrode and the cathode electrode can be prevented, so that operation defects or light-emitting defects can be prevented, and the product reliability can be improved.

The plurality of waterproof structures 125, 126-1 and 26-2 may be disposed in the display region AA and/or the non-display region NAA. For example, the plurality of waterproof structures 125, 126-1 and 26-2 may be disposed between the plurality of subpixels SPr, SPg and SPb in the first direction X and/or the second direction Y in the display region AA and/or the non-display region NAA. The plurality of waterproof structures 125, 126-1 and 26-2 may be disposed in the non- emission region NEA of each of the plurality of subpixels SPr, SPg and SPb in the first direction X and/or the second direction Y.

The plurality of waterproof structures may comprise a plurality of first waterproof structures 125, a plurality of second waterproof structures 126-1 and 126-2, a plurality of third waterproof structures, etc. As will be explained later, a plurality of first waterproof structures 125 and a plurality of second waterproof structures 126-1 and 126-2 may be provided on a plurality of first protrusion parts 124, and a plurality of third waterproof structures may be provided on a plurality of second protrusion parts 127. The third waterproof structure may block the passage through which moisture, oxygen, etc. penetrate into the connection structures 130-1 and 130-2, thereby deteriorating the connection characteristics and the passage through which moisture, oxygen, etc. penetrate into adjacent subpixels, thereby improving the reliability of products in high-humidity environments.

Meanwhile, the organic light-emitting layer, etc. is vulnerable to moisture, oxygen, etc., and when the organic light-emitting layer, etc. is damaged by moisture, oxygen, etc., the corresponding subpixels SPr, SPg, and SPb may not operate, resulting in light-emitting defects. When many subpixels SPr, SPg, and SPb do not operate due to moisture, oxygen, etc., display defects such as point light-emitting defects or region light-emitting defects may occur, resulting in reduced product reliability.

However, the plurality of waterproof structures 125, 126-1, and 26-2 as in the embodiment can prevent moisture, oxygen, etc. from penetrating into the non-display region NAA or the display region AA, thereby preventing operation defects or light-emitting defects of the subpixels SPr, SPg, and SPb. Accordingly, the organic light-emitting layers of the subpixels SPr, SPg, and SPb are not affected by moisture, oxygen, etc., so reliability can be dramatically improved.

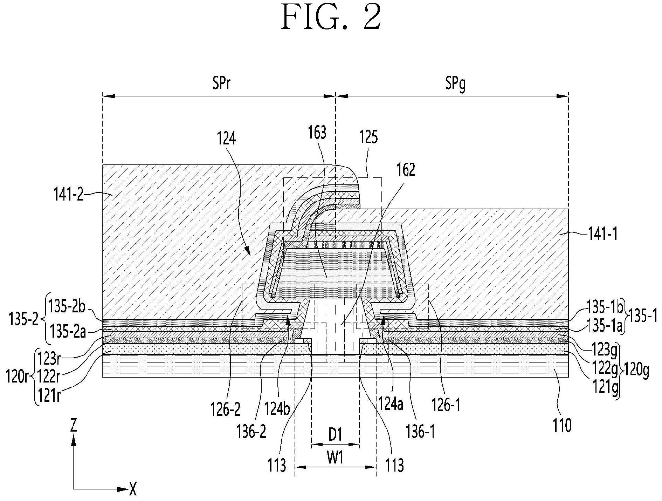

Meanwhile, instead of banks, column layers (162 in FIG. 2) may be disposed on the substrate between the plurality of subpixels SPr, SPg and SPb in the first direction X, and the banks may be disposed on the substrate between the plurality of subpixels SPr, SPg and SPb in the second direction Y. Instead of banks, column layers (162 in FIG. 2) may be disposed on the substrate between the plurality of subpixels SPr, SPg and SPb in the second direction Y.

In this instance, the width W1 between the emission region EA between the plurality of subpixels SPr, SPg, and SPb on the first direction X may be reduced to the width of the column layer of the first protrusion part 124, which is smaller than the width of the roof layer (163 in FIG. 2), so that the region of the emission region EA of each subpixel SPr, SPg, and SPb may be increased.

In the drawing, the dotted lines in the box illustrate the emission region EA (or its area) of each subpixel SPr, SPg, and SPb, and the solid lines may illustrate the plurality of subpixels SPr, SPg, and SPb that the plurality of waterproof structures 125, 126-1, and 26-2 have in a stripe form.

The width W1 between the emission regions EA may be determined by the width of some regions of the plurality of first protrusion parts 124 disposed between the plurality of subpixels SPr, SPg, and SPb on the first direction X, for example, the column layer. That is, since the width W1 between the emission regions EA is reduced by the width of the column layer, the region of the emission region EA of each subpixel SPr, SPg, and SPb may be increased, so that the lifespan can be increased at high luminance, and a high-luminance display can be implemented.

FIG. 2 is a cross-sectional view illustrating an organic light-emitting display device according to a first embodiment. FIG. 2 may be a cross-sectional view taken along the line A-A' in FIG. 1.

Although not illustrated, the region between the plurality of green subpixels SPg and the plurality of blue subpixels SPb in the first direction X or the region between the plurality of blue subpixels SPb and the plurality of red subpixels SPr in the first direction X may also have the same or similar structure as the region between the plurality of red subpixels SPr and the plurality of green subpixels SPg in the first direction X illustrated in FIG. 2.

As illustrated in FIG. 1 and FIG. 2, a first protrusion part 124 may be disposed on the substrate 110 between the red subpixel SPr and the green subpixel SPg in the first direction X. The first protrusion part 124 may be disposed lengthwise along the second direction Y between the red subpixel SPr and the green subpixel SPg in the first direction X, but is not limited thereto.

The left side portion and the right side portion of the first protrusion part 124 may have a shape symmetrical to each other with respect to the center normal of the first protrusion part 124. As will be described later, this may be because the roof layer 163 and the column layer 162 are formed in a single photolithography process.

The first protrusion part 124 may have a plurality of first undercut structures 124a and 124b. For example, a plurality of first undercut structures 124a and 124b may be formed on side portions of the first protrusion part 124.

The first protrusion part 124 may comprise a column layer 162 and a roof layer 163 on the column layer 162.

A plurality of first undercut structures 124a and 124b may be formed by the column layer 162 and the roof layer 163.

In order to form a plurality of first undercut structures 124a and 124b, the column layer 162 and the roof layer 163 may be formed of materials having different etching selectivities or etching rates. For example, the column layer 162 may comprise a material having a high etching rate, and the roof layer 163 may comprise a material having a low etching rate. Accordingly, when the photosensitive pattern is formed on the roof layer 163 and the column layer 162 and the roof layer 163 are etched, the side portions of the column layer 162 may be etched faster than the side portions of the roof layer 163, so that a plurality of first undercut structures 124a and 124b may be formed on the side portions of the first protrusion part 124. That is, the side portions of the column layer 162 may be recessed from the side portions of the roof layer 163 in an inward direction of the first protrusion part 124, so that a plurality of first undercut structures 124a and 124b may be formed.

The plurality of first undercut structures 124a and 124b may each have a cave shape. For example, the plurality of first undercut structures 124a and 124b may each have a U-shaped cave shape. Therefore, the first undercut structure 124a and 124b may be called a cave, a U cave, a cave part, etc.

The column layer 162 may be made of an inorganic insulating material. As the inorganic insulating material, a silicon oxide series material or a silicon nitride series material may be used.

The roof layer 163 may be made of a metal, an inorganic insulating material, etc. As the metal, titanium (Ti), molybdenum (Mo), molybdenum-titanium (MoTi), aluminum (Al), copper (Cu), and alloys thereof may be used. As the inorganic insulating material, a silicon oxide series material or a silicon nitride series material may be used.

Meanwhile, the red organic light-emitting element 120r may be disposed on the substrate 110 in the red subpixel SPr, and the green organic light-emitting element 120g may be disposed on the substrate 110 in the green subpixel SPg.

The red organic light-emitting element 120r may comprise a red anode electrode 121r, a red organic light-emitting layer 122r, a red cathode electrode 123r, etc. The green organic light-emitting element 120g may comprise a green anode electrode 121g, a green organic light-emitting layer 122g, a green cathode electrode 123g, etc.

The red anode electrode 121r and the green anode electrode 121g may be formed before the first protrusion part 124 is formed. That is, a conductive film may be formed and patterned on the substrate 110, so that the red anode electrode 121r and the green anode electrode 121g may be formed. The red anode electrode 121r and the green anode electrode 121g may be spaced apart from each other by a minimum distance D1 so that an electrical short does not occur. Thereafter, a first protrusion part 124 may be formed on the substrate 110 between the red subpixel SPr and the green subpixel SPg.

As described above, the first protrusion part 124 may comprise a column layer 162 and a roof layer 163. In order to form a plurality of first undercut structures 124a and 124b, a width W1 of the column layer 162 may be smaller than a width of the roof layer 163. In this instance, the side portions of the column layer 162 may be recessed inwardly of the first protrusion part 124 from the side portions of the roof layer 163 and be positioned within the plurality of first undercut structures 124a and 124b.

Using a deposition process, a green organic light-emitting layer 122g and a green cathode electrode 123g may be deposited on a substrate 110, and a first inorganic insulating layer 135-1 may be formed on the green cathode electrode 123g, and then the first inorganic insulating layer 135-1, the green cathode electrode 123g, and the green organic light-emitting layer 122g may be patterned together to form a green subpixel SPg.

Using a deposition process, a red organic light-emitting layer 122r and a red cathode electrode 123r may be deposited on a substrate 110, and a second inorganic insulating layer 135-2 may be formed on the red cathode electrode 123r, and then the second inorganic insulating layer 135-2, the red cathode electrode 123r, and the red organic light-emitting layer 122r may be patterned together to form a red subpixel SPr.

According to the embodiment, the green organic emitting layer 122g and the red organic emitting layer 122r may each be in contact with the side portions of the column layer 162. The width W1 of the column layer 162 becomes smaller, and the green organic emitting layer 122g and the red organic emitting layer 122r may each be in contact with the side portions of the column layer 162. Accordingly, the contact area between the green anode electrode 121g and the green organic light-emitting layer 122g and the contact area between the red anode electrode 121r and the red organic light-emitting layer 122r may be increased. Since the emission region EA is determined by the corresponding contact area, the emission region EA of the green subpixel SPg and the emission region EA of the red subpixel SPr may be increased. Accordingly, since the emission region EA is increased, lifespan and brightness can be increased, thereby improving the image quality.

Meanwhile, the first inorganic insulating layer 135-1 and the first organic insulating layer 141-1 may be disposed on the green organic light-emitting element 120g in the green subpixel SPg. For example, the first inorganic insulating layer 135-1 and the first organic insulating layer 141-1 may be disposed only on the green subpixel SPg, but not on the red subpixel SPr or the blue subpixel SPb.

The second inorganic insulating layer 135-2 and the second organic insulating layer 141-2 may be disposed on the red organic light-emitting element 120r in the red subpixel SPr. The second inorganic insulating layer 135-2 and the second organic insulating layer 141-2 may be disposed only on the red subpixel SPr, but not on the green subpixel SPg or the blue subpixel SPb.

The first inorganic insulating layer 135-1 may comprise two or more inorganic films 135-1a and 135-1b, each made of a different material. The second inorganic insulating layer 135-2 may comprise two or more inorganic films 135-2a and 135-2b, each made of a different material. For example, the first inorganic films 135-1a and 135-2a may comprise SiO₂, etc., and the second inorganic films 135-1b and 135-2b may comprise SiNx, etc., but is not limited thereto.

In this way, since the first inorganic insulating layer 135-1 and the second inorganic insulating layer 135-2 each comprise two or more inorganic films 135-1a, 135-1b, 135-2a, and 135-2b, the blocking performance against penetration of moisture, oxygen, etc. can be enhanced.

Meanwhile, the plurality of waterproof structures 125, 126-1, and 126-2 may be positioned between the plurality of subpixels SPr, SPg, and SPb on the first direction X. A plurality of waterproof structures 125, 126-1 and 126-2 may be disposed on a first protrusion part 124 positioned between a plurality of subpixels SPr, SPg and SPb on a first direction X.

The plurality of waterproof structures may comprise a first waterproof structure 125, a plurality of second waterproof structures 126-1 and 126-2, etc.

Since a plurality of waterproof structures, that is, the first waterproof structure 125 and the plurality of second waterproof structures 126-1 and 126-2, are disposed on the first protrusion part 124, penetration of moisture, oxygen, etc. can be completely blocked.

The first waterproof structure 125 may be configured such that two or more inorganic insulating layers among the plurality of inorganic insulating layers 135-1 and 135-2 are overlapped on a roof layer 163 of the first protrusion part 124.

As illustrated in FIG. 2, the first inorganic insulating layer 135-1 and the second inorganic insulating layer 135-2 may be overlapped on the roof layer 163 of the first protrusion part 124 disposed between the red subpixel SPr and the green subpixel SPg, so that the first waterproof structure 125 may be formed. For example, the second inorganic insulating layer 135-2 may be disposed on the first inorganic insulating layer 135-1.

As described above, since the peeling of the films is prevented by the first waterproof structure 125 overlapping each other, the occurrence of progressive dark spots due to peeled foreign substances can be reduced, thereby improving reliability. In addition, the penetration path of moisture, oxygen, etc. may be lengthened, thereby improving reliability for high-humidity products.

The first organic insulating layer 141-1 may be disposed between the first inorganic insulating layer 135-1 and the second inorganic insulating layer 135-2 on the roof layer 163 of the first protrusion part 124. In this instance, since one end region of the first organic insulating layer 141-1 on the first protrusion part 124 has a round surface, one end region of the second inorganic insulating layer 135-2 on the one end region of the first organic insulating layer 141-1 may also have a round surface.

As described above, it may be manufactured in the order of the green subpixel SPg, the red subpixel SPr and the blue subpixel SPb. That is, the green organic light-emitting element 120g, the first inorganic insulating layer 135-1, and the first organic insulating layer 141-1 may be patterned to manufacture the green subpixel SPg. Thereafter, the red organic light-emitting element 120r, the second inorganic insulating layer 135-2, and the second organic insulating layer 141-2 may be patterned to manufacture a red subpixel SPr. Thereafter, as illustrated in FIG. 3, the blue organic light-emitting element 120b, the third inorganic insulating layer 135-3, and the third organic insulating layer 141-3 may be patterned to manufacture a blue subpixel SPb.

Through these series of manufacturing processes, at least two or more inorganic insulating layers among the first inorganic insulating layer 135-1, the second inorganic insulating layer 135-2, and the third inorganic insulating layer 135-3 may be overlapped on the first protrusion part 124 between the plurality of subpixels SPr, SPg, and SPb in the first direction X, so that the first waterproof structure 125 may be formed.

For example, the first inorganic insulating layer 135-1 and the third inorganic insulating layer 135-3 may be overlapped on the first protrusion part between the green subpixel SPg and the blue subpixel SPb, so that the first waterproof structure may be formed. For example, the second inorganic insulating layer 135-2 and the third inorganic insulating layer 135-3 may be overlapped on the first protrusion part between the blue subpixel SPb and the red subpixel SPr, so that the first waterproof structure may be formed.

For example, the first inorganic insulating layer 135-1 and the second inorganic insulating layer 135-2 may be overlapped on the first protrusion part 124 between the red subpixel SPr and the green subpixel SPg, so that the first waterproof structure 125 may be formed.

As illustrated in FIG. 2, the first waterproof structure 125 may further comprise an island insulation pattern (not illustrated) in addition to the first inorganic insulating layer 135-1 and the second inorganic insulating layer 135-2. The island insulation pattern may be disposed on the second inorganic insulating layer 135-2. The island insulation pattern may be formed by the same patterning process with the same material as the third inorganic insulating layer 135-3, which is patterned and formed in the blue subpixel SPb.

Therefore, since the first waterproof structure 125 illustrated in FIG. 2 is formed by overlapping three inorganic insulating layers comprising the island insulation pattern, the moisture blocking performance of moisture, oxygen, etc. can be further enhanced.

Meanwhile, a plurality of second waterproof structures 126-1 and 126-2 may be disposed on the side portions of the first protrusion part 124. A plurality of second waterproof structures 126-1 and 126-2 may be disposed in a plurality of first undercut structures 124a and 124b of the first protrusion part 124.

When films comprising various materials are laminated, the penetration path of moisture, oxygen, etc. may be formed through the interface between the organic insulating layers 141-1 and 141-2 and the inorganic insulating layers 135-1 and 135-2 or through the material of the organic insulating layers 141-1 and 141-2 itself. Since the first waterproof structure 125 is positioned at the corresponding interface, oxygen, moisture, etc. may be penetrated along the corresponding interface. The first waterproof structure 125 may be formed as a structure in which the inorganic insulating layers 135-1 and 135-2 overlap, so that the penetration path may be lengthened.

Even if moisture, oxygen, etc. penetrate through the first waterproof structure 125, the second waterproofing structures 126-1 and 126-2 may have an interface-free region where the organic insulating layers 141-1 and 141-2 and the inorganic insulating layers 135-1 and 135-2 come into contact. Accordingly, moisture, oxygen, etc. may be completely blocked by the second waterproof structures 126-1 and 126-2. For example, the interface-free region may be the lower side of the roof layer 163 and/or the side portions of the column layer 162.

The interface may be a barrier part of a waterproof structure that can be secured when the deposition angle is greater than a certain deposition angle with respect to the horizontal plane of the substrate 110 by the angle limiting plate of the evaporation source during the deposition process. For example, when the etching depth of the lower side of the roof layer 163 is 0.5 µm and the height of the column layer 162 is 0.5 µm, the interface may be a barrier part that may be secured when deposited at a deposition angle of 45° or more.

One inorganic insulating layer among the plurality of inorganic insulating layers 135-1 and 135-2 may be formed as a joint structure of an inorganic film/an inorganic film by the plurality of first undercut structures 124a and 124b, so that a plurality of second waterproofing structures 126-1 and 126-2 may be formed. That is, the corresponding inorganic insulating layer may be disposed on the side portions of the column layer 162 and the lower side of the roof layer 163 in the plurality of first undercut structures 124a and 124b, so that a plurality of second waterproofing structures 126-1 and 126-2 having a joint structure of an inorganic film/an inorganic film may be formed.

Meanwhile, the open structures 136-1 and 136-2 may be disposed in an edge region of the first protrusion part 124. The open structures 136-1 and 136-2 may be disposed in the edge region of the column layer 162 of the first protrusion part 124.

The open structures 136-1 and 136-2 may comprise at least one or more blocking layer 113 for forming an undercut structure that is recessed inwardly from the side portions of the column layer 162. The blocking layer 113 may be recessed inwardly from the side portion of the column layer 162, so that the blocking structures 136-1 and 136-2 having an undercut structure may be formed. The blocking layer 113 may comprise a silicon-based inorganic material, a metal, etc. As the metal, aluminum (Al), molybdenum (Mo), a molybdenum alloy, etc. may be used, but is not limited thereto.

The first protrusion part 124 may have not only a waterproof characteristic but also a current leakage blocking characteristic. Nevertheless, open structures 136-1 and 136-2 may be provided to double reinforce the current leakage blocking. The open structures 136-1 and 136-2 may be formed through the same process as the open structures 137-1 and 137-2 illustrated in FIG. 3. When the image quality is less affected by the lateral leakage current, the open structures 137-1 and 137-2 may be omitted. In this instance, the open structures 136-1 and 136-2 may also be omitted, but are not limited thereto.

The transverse leakage current between the red subpixel SPr and the green subpixel SPg can be prevented by the open structures 136-1 and 136-2. The transverse leakage current may be a leakage current flowing between adjacent subpixels SPr and SPg along the first direction X. In addition, an electrical short between the anode electrodes 121r and 121g and the cathode electrodes 123r and 123g in the red subpixel SPr and the green subpixel SPg can be prevented by the open structures 136-1 and 136-2. Therefore, color spot due to the leakage current can be improved by using the open structures 136-1 and 136-2.

FIG. 3 is a cross-sectional view illustrating an organic light-emitting display device according to a second embodiment. FIG. 3 may be a cross-sectional view taken along the line B-B' in FIG. 1. FIG. 4 is a cross-sectional view illustrating an organic light-emitting display device according to a third embodiment. FIG. 4 may be a cross-sectional view taken along line C-C' in FIG. 1.

FIG. 3 illustrates a cross-sectional structure in a region between a plurality of blue subpixels SPb in the second direction Y. The cross-sectional structures in a region between a plurality of red subpixels SPr in the second direction Y and a region between a plurality of green subpixels SPg in the second direction Y may be the same as or similar to the cross-sectional structure in a region between a plurality of blue subpixels SPb in the second direction Y (FIG. 3).

As illustrated in FIG. 1 and FIG. 3, a plurality of second protrusion parts 127 may be disposed on a substrate 110 between a plurality of blue subpixels SPb in the second direction Y or at least between a non-display region NAA and a display region AA. The second protrusion part 127 may be provided in the form of a plurality of dummy pixels SPrd, SPgd, and SPbd in the non-display region NAA vulnerable to waterproofing, so that the waterproofing function can be strengthened when patterned by color. The shape of the pattern may be provided in the first direction X or the first direction X and the second direction Y.

The second protrusion part 127 may have a plurality of second undercut structures 127a and 127b. For example, the plurality of second undercut structures 127a and 127b may be formed on the side portions of the second protrusion part 127.

The second protrusion part 127 may comprise a column layer 162 and a roof layer 163. The second protrusion part 127 comprising the column layer 162 and the roof layer 163 may have the same shape as the first protrusion part 124 illustrated in FIG. 2.

The connection structures 130-1 and 130-2 linked to the structure of the second protrusion part 127 may be disposed between a plurality of subpixels SPr, SPg, and SPb in the form of stripes of the same color. Although there is a difference depending on the product, when the screen size is 8" or more in terms of diagonal, the connection structures 130-1 and 130-2 may be used to connect the auxiliary electrode and the first power wiring between the manufacturing processes, thereby improving the uniformity of brightness of the screen.

As illustrated in FIG. 4, the subpixels SPb of the same color may be distinguished by the column layer 162. In this instance, the column layer 162 may act as a bank.

The connection structures 130-1 and 130-2 may further comprise a floor layer. The floor layer may be disposed under the column layer 162. The floor layer may comprise an auxiliary electrode made of a material with excellent electrical conductivity, such as metal. Although not illustrated, the auxiliary electrode may be electrically connected to the first power wiring to which a first potential voltage is supplied.

Meanwhile, as illustrated in FIG. 4, the column layer 162 having a bank function may be disposed under the second protrusion part 127 between a plurality of subpixels SPb in the second direction Y. The third inorganic insulating layer 135-3 and the third organic insulating layer 141-3 may be disposed on the plurality of green subpixels SPg and the plurality of second protrusion parts 127 in the second direction Y. That is, the inorganic film and the organic film may be formed and patterned on the substrate 110, so that the third inorganic insulating layer 135-3 and the third organic insulating layer 141-3 may be disposed on the plurality of green subpixels SPg and the plurality of second protrusion parts 127 in the second direction Y.

As illustrated in FIG. 3, a plurality of third waterproof structures 128-1 and 128-2 may be disposed on the side portions of the second protrusion part 127. A plurality of third waterproof structures 128-1 and 128-2 may be disposed in a plurality of second undercut structures 127a and 127b of the second protrusion part 127.

A plurality of third waterproof structures 128-1 and 128-2 may be formed by forming a joint structure of an inorganic film/an inorganic film by a third inorganic insulating layer 135-3 by using a plurality of second undercut structures 127a and 127b. That is, the third inorganic insulating layer 135-3 may be disposed on the side portions of the column layer 162 and the lower side of the roof layer 163 in the plurality of second undercut structures 127a and 127b, so that a plurality of third waterproof structures 128-1 and 128-2 having a joint structure of an inorganic film/an inorganic film may be formed.

For example, a third-first waterproof structure 128-1 may be formed by the third inorganic insulating layer 135-3 being formed by using a second-first undercut structure 127a as a joint structure of an inorganic film/an inorganic film. For example, a third-second waterproof structure 128-2 may be formed by the third inorganic insulating layer 135-3 being formed by a second-second undercut structure 127b as a joint structure of an inorganic film/an inorganic film.

Since the plurality of third waterproofing structures 128-1 and 128-2 have a joint structure of an inorganic film/an inorganic film, the penetration path of moisture, oxygen, etc. may be increased, so that the penetration blocking performance can be further enhanced.

Meanwhile, the open structures 137-1 and 137-2 may be disposed in an edge region of the second protrusion part 127. The open structures 137-1 and 137-2 may be disposed in the edge region of the column layer 162 of the second protrusion part 127.

The open structures 137-1 and 137-2 may comprise at least one or more blocking layer 113 for forming an undercut structure that is recessed inwardly from the side portions of the column layer 162. By recessing inwardly from the side portions of the column layer 162, the open structures 137-1 and 137-2 may be formed with an undercut structure.

An electrical short between the blue anode electrode 121b and the blue cathode electrode 123b in the blue subpixel SPb can be prevented by the open structures 137-1 and 137-2. Therefore, by using the open structures 137-1 and 137-2, operation defects or light-emitting defects due to an electrical short between the blue anode electrode 121b and the blue cathode electrode 123b can be prevented, thereby increasing product reliability.

Meanwhile, as illustrated in FIG. 4, among a plurality of blue subpixels SPb in the second direction Y, the second protrusion part 127, the connection structures 130-1 and 130-2, the third waterproof structures 128-1 and 128-2, etc. may not be disposed between some blue subpixels SPb.

As illustrated in FIG. 1 and FIG. 3, a plurality of blue subpixels SPb in the second direction Y may be disposed on the entire region of the stripe pattern of the same color. The second protrusion part 127, the connection structures 130-1 and 130-2, the third waterproof structures 128-1 and 128-2, etc. may be disposed in units of three blue subpixels or units of three row lines along the second direction Y of the stripe pattern.

As illustrated in FIG. 4, since the second protrusion part 127, the connection structures 130-1 and 130-2, the third waterproof structures 128-1 and 128-2, etc. are not disposed, the blue organic light-emitting layer 122b or the blue cathode electrode 123b disposed on the column layer 162 may be continuously connected to the adjacent blue subpixel SPb without interruption.

Meanwhile, the open structures 138-1 and 138-2 may be disposed in the edge region of the column layer 162. The open structures 138-1 and 138-2 may be formed through the same process as the open structures 136-1, 136-2, 137-1 and 137-2 formed in the edge region of the column layer 162 of the first protrusion part 124 illustrated in FIG. 2 or the column layer 162 of the second protrusion part 127 illustrated in FIG. 3, but are not limited thereto.

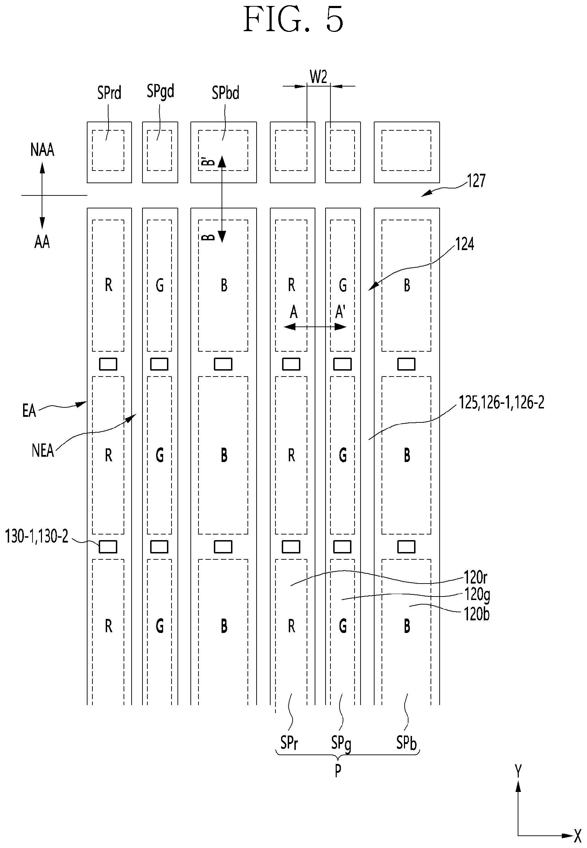

FIG. 5 is a plan view schematically illustrating an organic light-emitting display device according to a second embodiment.

The second embodiment is the same as the first embodiment (FIG. 1) except that the width W2 between the emission regions EA of the plurality of subpixels SPr, SPg and SPb along the first direction X is increased.

As will be explained later, a plurality of first banks may be disposed between a plurality of subpixels SPr, SPg, and SPb along the first direction X. Since the width of the first bank is greater than the width of the column layer of the first protrusion part, the emission region EA of the corresponding subpixels SPr, SPg, and SPb may be reduced due to the increase in the width of the first bank. Accordingly, in the second embodiment (FIG. 5), the width W2 between the emission regions EA of the plurality of subpixels SPr, SPg, and SPb along the first direction X may be greater than the width W1 between the emission regions EA of the plurality of subpixels SPr, SPg, and SPb along the first direction X in the first embodiment (FIG. 1).

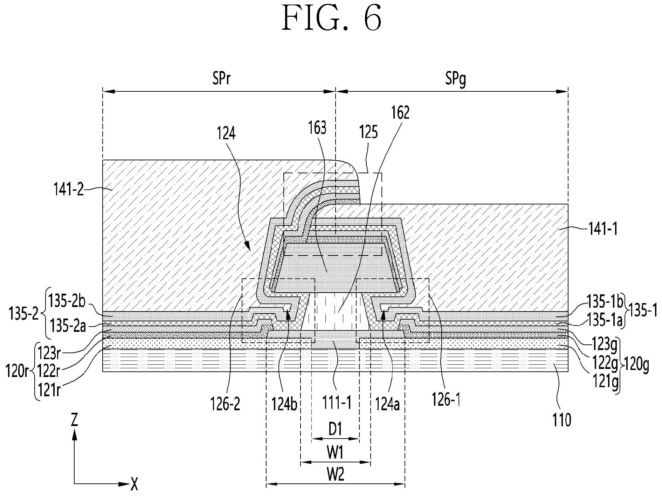

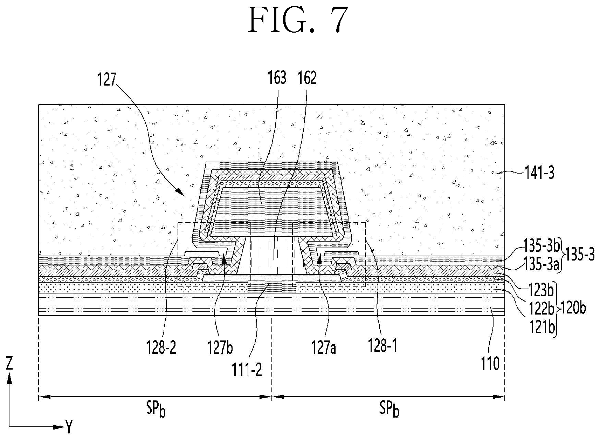

FIG. 6 is a cross-sectional view illustrating an organic light-emitting display device according to a fourth embodiment. FIG. 7 is a cross-sectional view illustrating an organic light-emitting display device according to a fifth embodiment. FIGS. 6 and 7 are cross-sectional views taken along lines A-A' and B-B' in FIG. 5, respectively.

As illustrated in FIG. 1, FIG. 6 and FIG. 7, a plurality of first banks 111-1 may be disposed on the substrate 110 between a plurality of subpixels SPr, SPg and SPb in the first direction X, and a plurality of second banks 111-2 may be disposed on the substrate 110 between a plurality of subpixels SPr, SPg and SPb in the second direction Y.

A plurality of first protrusion parts 124 may be disposed on a plurality of first banks 111-1 between a plurality of subpixels SPr, SPg and SPb in the first direction X, and a plurality of second protrusion parts 127 may be disposed on a plurality of second protrusion parts 127 between a plurality of subpixels SPr, SPg and SPb in the second direction Y.

The plurality of second banks 111-2, the plurality of first protrusion parts 124, and the plurality of second protrusion parts 127 have already been described, so that detailed descriptions thereof are omitted.

As illustrated in FIG. 6, the width W2 of the first bank 111-1 may be greater than the width W1 of the column layer 162 of the first protrusion part 124.

The red organic light-emitting element 120r may be disposed in the red subpixel SPr, and the green organic light-emitting element 120g may be disposed in the green subpixel SPg. The red organic light-emitting element 120r may comprise a red anode electrode 121r, a red organic light-emitting layer 122r, a red cathode electrode 123r, etc., and the green organic light-emitting element 120g may comprise a green anode electrode 121g, a green organic light-emitting layer 122g, a green cathode electrode 123g, etc.

The red anode electrode 121r and the green anode electrode 121g may be disposed to be spaced apart by a minimum distance D1 so that an electrical short circuit does not occur. The width W1 of the column layer 162 of the first protrusion part 124 may be greater than the spaced distance D1 between the red anode electrode 121r and the green anode electrode 121g.

The first bank 111-1 may be disposed on the red anode electrode 121r and the green anode electrode 121g. That is, the first bank 111-1 may vertically overlap a part of the red anode electrode 121r and a part of the green anode electrode 121g, respectively. In this instance, the contact area between the red anode electrode 121r and the red organic light-emitting layer 122r and the contact area between the green anode electrode 121g and the green organic light-emitting layer 122g may be reduced due to the first bank 111-1.

In addition, the green organic light-emitting layer 122g and/or the green cathode electrode 123g may be in contact with an upper surface of one side of the first bank 111-1, and the red organic light-emitting layer 122r and/or the red cathode electrode 123r may be in contact with an upper surface of the other side of the first bank 111-1.

Even if the deposition material is deposited on the substrate 110 at a relatively small deposition angle, the ends of the red organic light-emitting layer 122r, the red cathode electrode 123r, the green organic light-emitting layer 122g, and the green cathode electrode 123g may be formed at the entrances of the first undercut structures 124a and 124b, respectively. Accordingly, the deposition system is very simple, and the unit cost of the deposition system can be greatly reduced.

Meanwhile, the first waterproof structure 125 may be disposed on the first protrusion part 124, and a plurality of second waterproof structures 125, 126-1, and 26-2 may be disposed on the side portions of the first protrusion part 124.

Meanwhile, although not illustrated, as illustrated in FIG. 1, the cathode electrodes 123r, 123g, and 123b of the subpixels SPr, SPg, and SPb may be electrically connected to the power wiring through a plurality of connection structures 130-1 and 130-2 disposed between a plurality of subpixels SPr, SPg, and SPb on the second direction Y.

The connection methods and the connection structures may be implemented in various ways, such as laser welding, laser ablation, an undercut structure at a lower side of the bank, an undercut structure at an upper side of the bank, etc., but are not limited thereto.

Although not illustrated, an open structure may be provided at an edge region of the first bank 111-1 and/or the second bank 111-2.

The above detailed description should not be construed as limiting in all respects and should be considered illustrative. The scope of the embodiment should be determined by reasonable interpretation of the appended claims, and all changes within the equivalent range of the embodiment are included in the scope of the embodiment.

## Claims

1. An organic light-emitting display device, comprising:
a plurality of subpixels having different colors along a first direction and having a same color along a second direction crossing the first direction;
a plurality of anode electrodes on the plurality of subpixels;
a plurality of organic light-emitting layers on the plurality of anode electrodes;
a plurality of cathode electrodes on the plurality of organic light-emitting layers;
a plurality of inorganic insulating layers on the plurality of cathode electrodes;
a plurality of first protrusion parts disposed between the plurality of subpixels along the first direction and having a plurality of first undercut structures on side portions thereof;
a plurality of first waterproof structures on the plurality of first protrusion parts; and
a plurality of second waterproof structures in the plurality of first undercut structures of the plurality of first protrusion parts,
wherein the first waterproof structure is configured such that at least two or more inorganic insulating layers among the plurality of inorganic insulating layers are overlapped on the first protrusion parts.

2. The organic light-emitting display device of claim 1, wherein the first protrusion part comprises a column layer and a roof layer on the column layer,
wherein the first undercut structure is configured to be formed by a width of the column layer being smaller than a width of the roof layer, and
wherein the organic light-emitting layer is disposed on side portions of the column layer.

3. The organic light-emitting display device of claim 2, wherein a width between emission regions of the plurality of subpixels in the first direction is the width of the column layer.

4. The organic light-emitting display device of claim 1, wherein the second waterproof structure is configured such that one of the plurality of inorganic insulating layers is formed as a joint structure of an inorganic film/an inorganic film by the first undercut structure.

5. The organic light-emitting display device of claim 1, further comprising:
a plurality of second protrusion parts between the plurality of subpixels in the second direction.

6. The organic light-emitting display device of claim 5, further comprising:
a plurality of third waterproof structures on side portions of the plurality of second protrusion parts,
wherein the second protrusion parts comprise a column layer and a roof layer on the column layer, and
wherein a width of the column layer is smaller than a width of the roof layer, so that second undercut structures are formed on the side portions of the second protrusion part.

7. The organic light-emitting display device of claim 5, further comprising:
a plurality of connection structures on the second undercut structures of the second protrusion parts.

8. The organic light-emitting display device of claim 5, further comprising:
an open structure on an edge region of at least one or more of the first protrusion part and the second protrusion par.

9. The organic light-emitting display device of claim 1, further comprising:
a display regions comprising the plurality of sub-pixels;
a non-display regions comprising a plurality of dummy sub-pixels;
a plurality of third protrusions extending from the plurality of first protrusions to the non-display regions along the second direction; and
a plurality of third waterproof structures on the plurality of third protrusions.

10. The organic light-emitting display device of claim 1, further comprising:
a plurality of first banks below the plurality of first protrusion parts,
wherein the organic light-emitting layer is disposed on an upper side of the first bank.

11. The organic light-emitting display device of claim 10, further comprising:
a plurality of second banks between the plurality of subpixels in the second direction,
wherein the cathode electrode is disposed continuously on the subpixels adjacent to the second bank on the second bank.
